# EUROPÄISCHE PATENTANMELDUNG

(11) **EP 2 018 091 A2**
(43) Veröffentlichungstag der Anmeldung: **21.01.2009**
(21) Anmeldenummer: 08103709.5
(22) Anmeldetag: 24.04.2008
(51) Int. Cl.: H05K 3/34

(54) **Bauteil mit Lötpin**

(30) Priorität: 17.07.2007 AT 11182007
(71) Anmelder: Siemens AG Österreich, 1210 Wien (AT)
(72) Erfinder: Petricek, Martin, 2020, Hollabrunn (AT)
(74) Vertreter: Maier, Daniel Oliver

(57) **Zusammenfassung**

Die Erfindung betrifft eine Anordnung mit wenigstens einem Lötpin (1), welcher an einem Bauteil (2) fixiert ist, wobei das Bauteil (2) eine Vorderseite (3) und eine Rückseite (4) aufweist und wobei ein erster Endabschnitt (7) des Lötpins (1) zum Einlöten in eine Leiterplatte über einen Rand des Bauteils (2) hinausragt und wobei das Bauteil (2) einen Durchbruch (5) von der Vorder- zur Rückseite aufweist. Dabei umfasst der Lötpin (1) einen Mittelabschnitt (8) und einen zweiten Endabschnitt (9) in der Weise, dass der erste und der zweite Endabschnitt (7, 9) durch den Durchbruch (5) hindurchgeführt sind und dass sich die beiden Endabschnitte (7, 9) auf der Rückseite (4) des Bauteils (2) abstützen und sich der Mittelabschnitt (8) auf der Vorderseite (3) des Bauteils (2) abstützt.

## Beschreibung

Die Erfindung betrifft eine Anordnung mit wenigstens einem Lötpin, welcher an einem Bauteil fixiert ist, wobei das Bauteil eine Vorderseite und eine Rückseite aufweist und wobei ein erster Endabschnitt des Lötpins zum Einlöten in eine Leiterplatte über einen Rand des Bauteils hinausragt. Des Weiteren betrifft die Erfindung ein Verfahren zur Montage einer erfindungsgemäßen Anordnung.

Bei vielen Schaltungsanordnungen besteht die Notwendigkeit, einen Bauteil wie zum Beispiel einen Kühlkörper, ein Abschirmblech, ein Montageelement etc. mittels Lötpins auf einer Leiterplatte zu befestigen. Der Bauteil ist dann vorzugsweise im Schwalllötverfahren mit der Leiterplatte mechanisch und elektrisch kontaktierbar. Für den Fall, dass der Bauteil eine lötfähige Oberfläche aufweist oder mit einem lötfähigen Überzug versehen ist, besteht die Möglichkeit, den Bauteil und die Lötpins einstückig auszubilden.

In vielen Fällen ist jedoch eine solche einstückige Ausführung nicht möglich, beispielsweise wenn bei Bauteilen mit nicht lötbaren Oberflächen ein galvanisches oder chemisches Verzinnen oder Vernickeln unerwünscht ist oder wenn die Ausformung von Lötfahnen am Bauteil aus fertigungstechnischen Gründen nicht in Frage kommt. Nach dem Stand der Technik kennt man deshalb unterschiedliche Arten der Befestigung eines Lötpins an einem Bauteil.

Nach der DE 696 32 865 T2 ist beispielsweise eine Haltevorrichtung für einen Kühlkörper offenbart, welcher Lötfahnen zur Befestigung auf einer Leiterplatte aufweist. Dabei ist die Haltevorrichtung in der Weise ausgebildet, dass sie einerseits in entsprechend geformte Führungsrillen des Kühlkörpers einschiebbar ist und dass sie andererseits eine Aufnahme für ein elektrisches Bauelement umfasst.

Eine allgemein anwendbare Befestigungsart eines Lötpins an einem Kühlkörper ist in der US 4 544 942 A1 beschrieben. Der aus Blech gefertigte Lötpin weist dabei einen ersten Abschnitt auf, der im befestigten Zustand als Lötfahne über den Rand des Bauteils hinausragt. Ein zweiter Abschnitt des Lötpins ist als flacher Kopf mit einem konischen Durchbruch ausgebildet. Dabei liegt der Kopf des Lötpins auf der Oberfläche des Kühlkörpers auf und ist mittels einer in den Durchbruch gepressten Ausstülpung des Kühlkörpers an diesem fixiert.

Man kennt darüber hinaus noch Befestigungsarten mit Befestigungsmitteln wie Nieten, Schrauben etc.

Der Erfindung liegt die Aufgabe zugrunde, für eine Anordnung der eingangs genannten Art eine Verbesserung gegenüber dem Stand der Technik anzugeben.

Erfindungsgemäß wird diese Aufgabe gelöst durch eine Anordnung mit wenigstens einem Lötpin, welcher an einem Bauteil fixiert ist, wobei das Bauteil im Bereich des Lötpins eine Vorderseite und eine Rückseite aufweist und wobei ein erster Endabschnitt des Lötpins zum Einlöten in eine Leiterplatte über einen Rand des Bauteils hinausragt und wobei des Weiteren das Bauteil einen Durchbruch von der Vorder- zur Rückseite aufweist. Dabei umfasst der Lötpin einen Mittelabschnitt und einen zweiten Endabschnitt in der Weise, dass der erste und der zweite Endabschnitt durch den Durchbruch hindurchgeführt sind und dass sich die beiden Endabschnitte auf der Rückseite des Bauteils abstützen und sich der Mittelabschnitt auf der Vorderseite des Bauteils abstützt.

Des Weitern wird die Aufgabe durch ein Montageverfahren für eine erfindungsgemäße Anordnung gelöst, wobei zunächst der erste Endabschnitt des Lötpins durch den Durchbruch des Bauteils geführt wird und wobei im Anschluss daran der zweite Endabschnitt des Lötpins durch den Durchbruch des Bauteils geführt wird, bis ein Bereich des Mittelabschnitts des Lötpins auf der Vorderseite des Bauteils aufliegt.

Das Bauteil ist somit lediglich mit einem Durchbruch zu versehen, in welchen der Lötpin eingesetzt wird, ohne dass dabei Einpresswerkzeuge oder spezielle Montagevorrichtungen notwendig sind. Die erfindungsgemäße Anordnung und das erfindungsgemäße Montageverfahren stellen somit einerseits eine einfache und somit kostengünstige Fertigung des Bauteils und des Lötpins und andererseits eine funktionelle und stabile elektrische und mechanische Kontaktierung zwischen Lötpin und Bauteil sicher.

Die erfindungsgemäße Anordnung ist besonders vorteilhaft, wenn das Bauteil eine nicht lötbare Oberfläche aufweist.

Für die Fertigung des Lötpins ist es von Vorteil, wenn dieser als gebogenes, im Wesentlichen Streifenförmiges Blechstück ausgebildet ist. Dabei ist es günstig, wenn der Mittelabschnitt des Lötpins breiter als die Endabschnitte ausgebildet ist, sodass der Mittelabschnitt seitlich über den Rand des Durchbruchs hinausragt. Auf diese Weise ist eine einfache, leicht zu fertigende und stabile Form gegeben, welche die Funktion ohne Einschränkungen erfüllt.

Des Weiteren ist es vorteilhaft, wenn die beiden Endabschnitte des Lötpins zueinander gefedert ausgebildet sind. Durch eine federnde Ausbildung sind bei der Fertigung des Lötpins größere Toleranzen zulässig, weil die Anpresskräfte an den Kontaktstellen zwischen Lötpin und Bauteil nicht allein durch die Passform der beiden Kontaktpartner sondern auch durch die Federkraft des im montierten Zustand elastisch verformten Lötpins aufgebracht werden. Dabei besteht auch die Möglichkeit, den federnden Lötpin zur weiteren Stabilisierung der Kontaktierung bei der Montage vorzuspannen.

In einer verbesserten Ausprägung der Erfindung ist zudem vorgesehen, dass die Abstützung des zweiten Endabschnitts des Lötpins auf der Rückseite des Bauteils als Verrastung am Rand des Durchbruchs mittels einer am zweiten Endabschnitt angeordneten Auskragung ausgebildet ist. Damit wird wiederum die Stabilität der Kontaktierung erhöht.

Zur Kontaktierung des Lötpins mit einem Kontaktdraht ist es vorteilhaft, wenn der Mittelabschnitt eine Bohrung zum Einlöten eines Drahtendes aufweist.

Um die elektrische Kontaktierung des Lötpins mit dem Bauteil zu verbessern, ist es von Vorteil, wenn der Lötpin als Stanzteil ausgebildet ist und wenn ein Stanzgrat des Lötpins zumindest an einer Stelle gegen das Bauteil gedrückt ist. Der keilförmige Stanzgrat dringt dabei in die Oberfläche des Bauteils ein, wodurch die Kontaktfläche zwischen den Kontaktpartnern vergrößert wird. Zudem stellt Stanzen ein einfaches und kostengünstiges Fertigungsverfahren zur Herstellung des Lötpins dar.

In einer weiteren Ausprägung der Erfindung ist das Bauteil als Kühlkörper ausgebildet. Dabei sind beispielsweise Kühlkörper aus Aluminium in einfacher Weise elektrisch und mechanisch mit einer Leiterplatte kontaktierbar.

Für einen stabilen Halt des Lötpins im Durchbruch des Bauteils ist es zudem günstig, wenn der Durchbruch des Bauteils einen im Wesentlichen rechteckigen Querschnitt aufweist.

Die Erfindung wird nachfolgend in beispielhafter Weise unter Bezugnahme auf die beigefügten Figuren erläutert. Es zeigen in schematischer Darstellung:
- Fig. 1: Anordnung mit Bauteil und zwei Lötpins
- Fig. 2: Schrägansicht eines montierten Lötpins mit geschnitten dargestelltem Bauteil
- Fig. 3: Lötpin in vorderer Schrägansicht
- Fig. 5: Lötpin in hinterer Schrägansicht

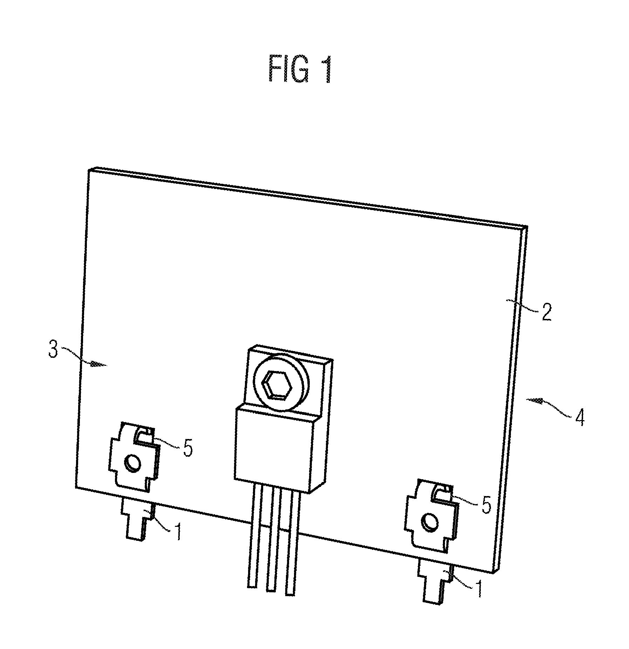

Figur 1 zeigt beispielhaft ein als Kühlkörper ausgebildetes Bauteil 2 mit einem auf diesem befestigten elektronischen Bauelement. Die Festlegung einer Vorderseite 3 und Rückseite 4 ist zur besseren Beschreibbarkeit der Erfindung beliebig gewählt und hat keinen Einfluss auf die Wirkungsweise der Erfindung.

Neben den Lötfahnen des elektronischen Bauelements ragen die ersten Endabschnitte 7 der beiden Lötpins 1 über den unteren Rand des Bauteils 2 hinaus. Die Anordnung ist somit geeignet, mit dem unteren Rand des Bauteils 2 auf eine Leiterplatte aufgesetzt zu werden, wobei die Lötfahnen des elektronischen Bauelements und die über den Rand des Bauteils 2 hinausragenden ersten Endabschnitte 7 der Lötpins 1 durch Löcher in der Leiterpatte geführt und an der Unterseite der Leiterplatte verlötet werden.

Die Lötpins 1 sind beispielhaft als gebogene Stanzteile ausgebildet, wobei abhängig von der Form und der Masse des Bauteils 2 unterschiedlich viele Lötpins 1 vorzusehen sind, um eine stabile Fixierung des Bauteils 2 auf einer Leiterplatte sicherzustellen. Für jeden Lötpin 1 ist ein Durchbruch 5 des Bauteils 2 vorgesehen.

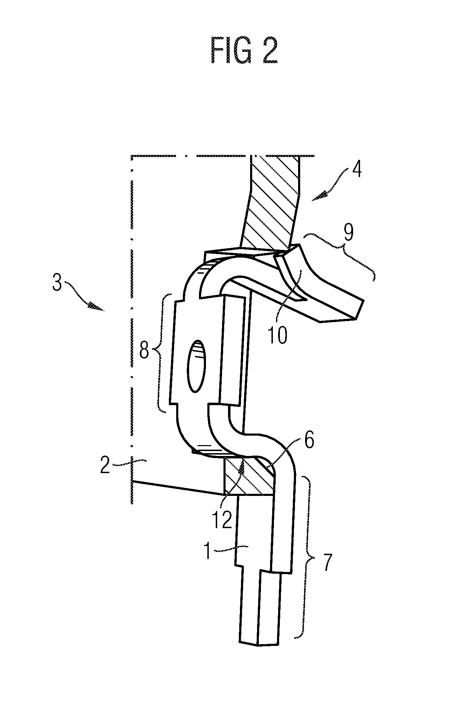

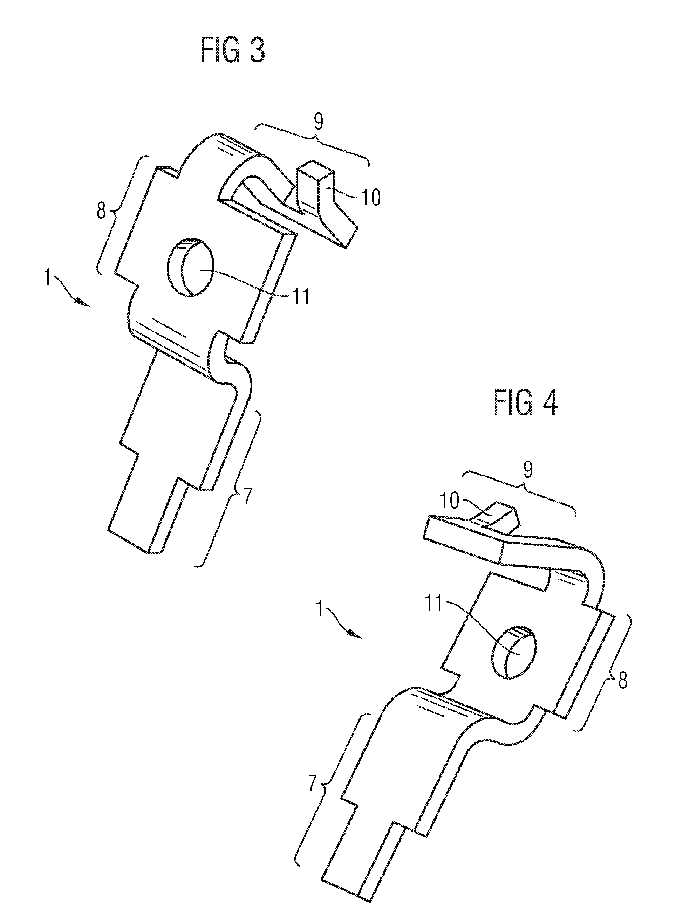

In Figur 2 ist eine detaillierte Darstellung des in einen Durchbruch 5 eingesetzten Lötpins 1 abgebildet. Das Bauteil 2 ist dabei geschnitten dargestellt, um die Kontaktstellen des Lötpins 1 mit dem Bauteil 2 sichtbar zu machen. Die Figuren 3 und 4 zeigen Schrägdarstellungen des Lötpins 1 mit der in Figur 2 dargestellten beispielhaften Ausführungsform.

Der Lötpin 1 weist einen Mittelabschnitt 8 mit rechteckiger Form auf, wobei dieser rechteckige Mittelabschnitt 8 seitlich über den vorderseitigen Rand des Durchbruchs 5 hinausragt und somit an der Vorderseite des Bauteils 2 abgestützt ist. Der Mittelabschnitt 8 weist zudem beispielhaft eine Bohrung 11 auf, die zum Einlöten von Kontaktdrähten geeignet ist.

Der Mittelabschnitt 8 des Lötpins geht über Abkantungen in die beiden Endabschnitte 7, 9 des Lötpins 1 über. Der erste Endabschnitt 7 ist dabei in der Weise über eine doppelte Abkantung in S-Form mit dem Mittelabschnitt 8 verbunden, dass der S-förmige Abschnitt im Durchbruch 5 angeordnet ist und der erste Endabschnitt 7 parallel zum Mittelabschnitt 8 verlaufend auf der Rückseite des Bauteils 2 abgestützt ist. Der S-förmige Abschnitt des Lötpins 1 stützt sich dabei auf der Innenwand des Durchbruchs 5 ab, wobei die Breite dieses S-förmigen Abschnitts der Breite des Durchbruchs 5 entspricht. Die von dieser Innenwand und der Oberfläche an der Rückseite des Bauteils 2 gebildete Kante ist günstigerweise mit einer Fase 6 versehen, um die Abkantung des Lötpins 1 an dieser Stelle freizustellen.

Der erste Endabschnitt 7 des Lötpins 1 ist wiederum in zwei Abschnitte unterteilt, wobei ein erster Abschnitt zur Abstützung an der Rückseite 4 des Bauteils 2 mit konstantem Querschnitt in den S-förmigen Abschnitt übergeht. Ein zweiter Abschnitt ist als Lötfahne zur Durchführung durch eine Leiterplatte ausgebildet und weist einen geringeren Querschnitt auf.

Der zweite Endabschnitt 9 des Lötpins ist mit einer Abkantung an den Mittelabschnitt 8 angeschlossen. Der zweite Endabschnitt 9 weist dabei wieder eine geringere Breite als der Mittelabschnitt 8 auf, sodass er zur Durchführung durch den Durchbruch 5 geeignet ist. Der Abkantungswinkel beträgt dabei zwischen ca. 90° und ca. 135°, um das Einsetzen des Lötpins 1 in den Durchbruch 5 zu ermöglichen. Das Einsetzen geschieht dabei in der Weise, dass zunächst der erste Endabschnitt 7 durch den Durchbruch 5 geführt wird und dass dann durch eine Kippbewegung über einen Kipppunkt an der Kontaktstelle zwischen der Innenwand des Durchbruchs 5 und dem S-förmigen Abschnitt des Lötpins 1 der zweite Endabschnitte 9 durch den Durchbruch 5 geführt wird, bis der Mittelabschnitt 8 mit seinen seitlichen Überständen auf der Vorderseite 3 des Bauteils 2 abgestützt ist. Dieser Vorgang ist vorteilhafterweise ohne Werkzeuge per Hand durchführbar.

Zur Abstützung des zweiten Endabschnitts 9 auf der Rückseite 4 des Bauteils 2 ist beispielhaft eine Auskragung 10 vorgesehen. Diese Auskragung 10 bewirkt, dass der zweite Endabschnitt 9 während des Einsetzens des Lötpins 1 in den Durchbruch 5 in Richtung des Kipppunkts federt. In der Endposition rastet die Auskragung 10 am Rand des Durchbruchs 5 ein und fixiert auf diese Weise den Lötpin 1 in dieser Position. Alternativ dazu kann der zweite Endabschnitt 9 nach der Durchführung durch den Durchbruch 5 durch eine erneute Abkantung an der Rückseite 4 des Bauteils 2 abgestützt werden.

Eine einfache Ausführung der Auskragung 10 sieht vor, dass der zweite Endabschnitt 9 des Lötpins 4 geschlitzt ausgebildet ist, wobei zwei durch einen Schlitz gebildete Schenkel durch einen Verbindungssteg am Ende des zweiten Endabschnitt 9 miteinander verbunden sind. Ein Schenkel ist über die Abkantung an den Mittelabschnitt 8 des Lötpins 1 angeschlossen. Der zweite Schenkel ist durch eine vom ersten Endabschnitt 7 wegweisenden Abkantung als Auskragung 10 ausgebildet. Der Abkantungswinkel liegt dabei zwischen ca. 10° und ca. 45°. Dabei ist der Winkel der Dicken des Bauteils 2 und dem Abkantungswinkel zwischen Mittelabschnitt 8 und zweitem Endabschnitt 9 in der Weise anzupassen, dass einerseits der zweite Endabschnitt 9 durch den Durchbruch 5 hindurchgeführt werden kann und dass andererseits eine Verrastung der Auskragung 10 am rückseitigen Rand des Durchbruchs 5 möglich ist.

Die elektrische Kontaktierung zwischen einem als Stanzteil ausgebildeten Lötpin 1 und einem Bauteil 2 wird dadurch verbessert, dass der Stanzgrat 12 in die Innenwand des Durchbruchs 5 gedrückt ist.

## Patentansprüche

1. Anordnung mit wenigstens einem Lötpin (1), welcher an einem Bauteil (2) fixiert ist, wobei das Bauteil (2) eine Vorderseite (3) und eine Rückseite (4) aufweist und wobei ein erster Endabschnitt (7) des Lötpins (1) zum Einlöten in eine Leiterplatte über einen Rand des Bauteils (2) hinausragt, **dadurch gekennzeichnet, dass** das Bauteil (2) einen Durchbruch (5) von der Vorderseite (3) zur Rückseite (4) aufweist, dass der Lötpin (1) einen Mittelabschnitt (8) und einen zweiten Endabschnitt (9) in der Weise umfasst, dass der erste und der zweite Endabschnitt (7, 9) durch den Durchbruch (5) hindurchgeführt sind und dass sich die beiden Endabschnitte (7, 9) auf der Rückseite (4) des Bauteils (2) abstützen und sich der Mittelabschnitt (8) auf der Vorderseite (3) des Bauteils (2) abstützt.

2. Anordnung nach Anspruch 1, **dadurch gekennzeichnet, dass** das Bauteil (2) eine nicht lötbare Oberfläche aufweist.

3. Anordnung nach Anspruch 1 oder 2, **dadurch gekennzeichnet, dass** der Lötpin (1) als gebogenes, im Wesentlichen steifenförmiges Blechstück ausgebildet ist.

4. Anordnung nach einem der Ansprüche 1 bis 3, **dadurch gekennzeichnet, dass** der Mittelabschnitt (8) des Lötpins (1) breiter als die Endabschnitte (7, 9) ausgebildet ist, sodass der Mittelabschnitt (8) seitlich über den Rand des Durchbruchs (5) hinausragt.

5. Anordnung nach einem der Ansprüche 1 bis 4, **dadurch gekennzeichnet, dass** die beiden Endabschnitte (7, 9) zueinander gefedert ausgebildet sind.

6. Anordnung nach einem der Ansprüche 1 bis 5, **dadurch gekennzeichnet, dass** die Abstützung des zweiten Endabschnitts (9) des Lötpins (1) auf der Rückseite (4) des Bauteils (2) als Verrastung am Rand des Durchbruchs (5) mittels einer am zweiten Endabschnitt (9) angeordneten Auskragung (10) ausgebildet ist.

7. Anordnung nach einem der Ansprüche 1 bis 6, **dadurch gekennzeichnet, dass** der Mittelabschnitt (8) eine Bohrung (11) zum Einlöten eines elektrischen Anschlusskontakts aufweist.

8. Anordnung nach einem der Ansprüche 1 bis 7, **dadurch gekennzeichnet, dass** der Lötpin (1) als Stanzteil ausgebildet ist und dass ein Stanzgrat (12) des Lötpins (1) zumindest an einer Stelle gegen das Bauteil (2) gedrückt ist.

9. Anordnung nach einem der Ansprüche 1 bis 8, **dadurch gekennzeichnet, dass** das Bauteil (2) als Kühlkörper ausgebildet ist.

10. Anordnung nach einem der Ansprüche 1 bis 9, **dadurch gekennzeichnet, dass** der Durchbruch (5) einen im Wesentlichen rechteckigen Querschnitt aufweist.

11. Verfahren zur Montage einer Anordnung nach einem der Ansprüche 1 bis 10, **dadurch gekennzeichnet, dass** zunächst der erste Endabschnitt (7) des Lötpins (1) durch den Durchbruch (5) des Bauteils (2) geführt wird und dass im Anschluss daran der zweite Endabschnitt (9) des Lötpins (1) durch den Durchbruch (5) des Bauteils (2) geführt wird, bis ein Bereich des Mittelabschnitts (8) des Lötpins (1) auf der Vorderseite des Bauteils (2) aufliegt.
